Europäisches Patentamt

European Patent Office

Office européen des brevets

(19)

(11) Veröffentlichungsnummer: **0 498 139 A1**

# (12) EUROPÄISCHE PATENTANMELDUNG

(21) Anmeldenummer: **91810077.7**

(22) Anmeldetag: **04.02.91**

(51) Int. Cl.5: **B05C 5/00**

Der Patentanspruch 11 gilt durch Nichtzahlung der Anspruchsgebühr als verzichtet (Regel 31 (2) EPÜ).

(43) Veröffentlichungstag der Anmeldung:
**12.08.92 Patentblatt 92/33**

(84) Benannte Vertragsstaaten:
**CH LI**

(71) Anmelder: **CIBA-GEIGY AG**
**Klybeckstrasse 141**
**CH-4002 Basel(CH)**

(72) Erfinder: **Ekman, Anders**
**Högenvägen 74**
**S-430 50 Kallered(SE)**

(54) **Verfahren und Vorrichtung zur Beschichtung von Platten.**

(57) Bei dem Verfahren wird eine zu beschichtende Platte (2) längs einer Transportbahn unter einem herabfallenden Vorhang aus flüssiger Beschichtungsmasse vorbei transportiert und in der Auftrefflinie (L) von der herabfallenden Beschichtungsmasse beaufschlagt. Die Platte (2) und der Giessvorhang bzw. die Auftrefflinie (L) werden dabei so gegeneinander ausgerichtet, dass die vorlaufenden Plattenkante (20) und der Giessvorhang bei der Beschichtung einen spitzen Winkel (α) einschliessen.

EP 0 498 139 A1

Die Erfindung betrifft ein Verfahren und eine Vorrichtung zur Beschichtung von Platten gemäss Oberbegriff von Patentanspruch 1 bzw. Patentanspruch 5.

Derartige Verfahren und Vorrichtungen sind in verschiedenen Ausführungsformen bekannt. Beispiele für solche Vorrichtungen sind in der US-A-4,559,896 oder in der US-A-4,926,789 der Anmelderin beschrieben. Bei der in der erstgenannten Druckschrift beschriebenen Vorrichtung wird eine zu beschichtende Platte längs einer Transportbahn unter einem von einem Giesskopf erzeugten Giessvorhang aus einer flüssigen Masse hindurch transportiert, wobei der Giessvornag von oberhalb der Transportbahn frei herabfällt. Der Giessvorhang erstreckt sich dabei stets senkrecht zur Transportrichtung der Platte, deren vorlaufende Plattenkante sich ebenfalls senkrecht zur Transportrichtung erstreckt. Die zu beschichtende Platte wird durch die flüssige Masse des herabfallenden Giessvorhangs längs der Auftrefflinie des Giessvorhangs beaufschlagt und so beschichtet.

Solche Vorrichtungen eignen sich beispielsweise zur Beschichtung von Leiterplatten, auf die die Leiterbahnen schon aufgebracht sind, und die beispielsweise mit einem als Lötstopplack wirkenden lichthärtbaren Kunstofflack beschichtet werden sollen. Dabei verlaufen in den Randbereichen der Platten, also in der Nähe der Plattenkanten, üblicherweise keine oder nur wenige Leiterbahnen. Diese verlaufen üblicherweise in Bereichen, die weiter innen auf der Oberfläche der Leiterplatte liegen, und zwar normalerweise im wesentlichen parallel zu den Plattenkanten und aus elektrischen Gründen auch parallel bzw. senkrecht zueinander.

Die oben beschriebene Beschichtungsvorrichtung ist an sich brauchbar, weist aber noch gewisse Verbesserungsmöglichkeiten auf. So kann es beispielsweise vorkommen, dass bei der beschriebenen Beschichtungsvorrichtung zwischen den Leiterbahnen Lufteinschlüsse im Lötstopplack auftreten. Da die Beschichtung senkrecht zu den Leiterbahnen erfolgt, können derartige Lufteinschlüsse nicht "abtransportiert" werden.

Weiterhin kann es je nach Leiterbahnhöhe und Abstand der Leiterbahnen untereinander auch zu unbeschichteten Bereichen kommen bzw. gelangt nur eine ungenügende Menge Lötstopplack zwischen die Leiterbahnen. Bei geringem Leiterbahnabstand und grosser Leiterbahnhöhe, was hinsichtlich hoher Packungsdichte und guter elektrischer Eigenschaften sehr wünschenswert ist, schirmen die Leiterbahnen die Bereiche zwischen den Leiterbahnen, die mit Lötstopplack beschichtet werden sollen, quasi ab, so dass der Lötstopplack nicht bis an die Leiterbahnen heranreicht.

Diese Mängel werden durch das Verfahren bzw. durch die Vorrichtung gemäss der Erfindung behoben. Bei dem Verfahren gemäss der Erfindung werden die Platten und der Giessvorgang so gegeneinander ausgerichtet, dass die vorlaufenden Plattenkanten und damit auch die Leiterbahnen, die ja üblicherweise parallel zu den Plattenkanten verlaufen, mit dem Giessvorgang einen spitzen Winkel einschliessen. Dadurch wird erreicht, dass die Beschichtungsmasse, im oben beschriebenen Beispiel der Lötstopplack, einen eventuell auftretenden Lufteinschluss quasi bis zum Plattenrand hin "vor sich hertreiben" und somit abtransportieren kann. Ausserdem wird auf diese Weise auch erreicht, dass auch bei grossen Leiterbahnhöhen und geringen Leiterbahnabständen eine ausreichende Menge an Lötstopplack in die Bereiche zwischen den Leiterbahnen gelangt.

Um diesen spitzen Winkel zwischen dem Giessvorhang und den Plattenkanten bzw. den Leiterbahnen auf der Platte zu erreichen bieten sich insbesondere zwei Ausführungsvarianten des Verfahrens an. So verläuft gemäss der einen Ausführungsvariante der Giessvorhang im wesentlichen senkrecht zur Transportrichtung der Platten und die Platten werden so positioniert, dass ihre vorlaufenden Kanten den spitzen Winkel mit dem Giessvorhang einschliessen, was beispielsweise durch ein Verdrehen der Platten erfolgen kann.

Gemäss der anderen Ausführungsvariante des Verfahrens werden die zu beschichtenden Platten mit im wesentlichen senkrecht zur Transportrichtung ausgerichteten vorlaufenden Kanten durch die Beschichtungszone transportiert und der Giessvorhang ist so angeordnet, dass die Auftrefflinie des Giessvorhangs schräg zur Transportrichtung geneigt ist, so dass auf diese Weise der spitze Winkel zwischen den vorlaufenden Plattenkanten bzw. den Leiterbahnen und dem Giessvorhang eingeschlossen wird.

Der eingeschlossene spitze Winkel ist dabei etwa kleiner 20° und liegt vorzugsweise im Bereich von etwa 5° bis 15°.

Die entsprechende Vorrichtung zur Beschichtung solcher Platten umfasst, wie in der Einleitung bereits diskutiert, einen Giesskopf zur Erzeugung eines frei fallenden Giessvorhangs aus flüssiger Beschichtungsmasse. In dem oben beschriebenen Beispiel handelt es sich dabei um den Lötstopplack. Ferner umfasst sie Transportmittel, die die zu beschichtenden Platten längs einer Transportbahn unter dem Giesskopf vorbei transportieren, so dass der Giessvorhang in der Beschichtungszone die Platten beaufschlagt. Der Giessvorhang und die Transportmittel sind dabei so ausgebildet bzw. angeordnet, dass die vorlaufenden Kanten der zu beschichtenden Platten während der Beschichtung mit dem Giessvorhang einen spitzen Winkel einschliessen. Dadurch wird erreicht, dass die Beschichtungsmasse, im oben beschriebenen Beispiel der Lötstopplack, einen eventuell auftretenden Lufteinschluss quasi bis zum Plattenrand hin "vor sich hertreiben" und somit abtransportieren kann. Ausserdem wird auf diese Weise auch erreicht, dass auch bei grossen Leiterbahnhöhen und geringen Leiterbahnabständen eine ausreichende Menge an Lötstopplack in die Bereiche zwischen den Leiterbahnen gelangt.

Um zu erreichen, dass die vorlaufenden Plattenkanten bzw. die auf der Platte aufgebrachten Leiterbahnen mit dem Giessvorhang während der Beschichtung einen spitzen Winkel einschliesst, bieten sich insbesondere zwei Ausführungsvarianten der Vorrichtung an. Bei der ersten Variante umfassen die Transportmittel eine Positioniereinrichtung, die die Platten vor der Beschichtung so positioniert, dass die vorlaufenden Kanten der Platten bzw. die Leiterbahnen auf der Platte mit einer zur Transportrichtung senkrechten Linie den spitzen Winkel einschliessen. Der Giesskopf ist gleichzeitig so angeordnet, dass die Auftrefflinie des Giessvorhangs im wesentlichen senkrecht zur Transportrichtung der Platte verläuft.

Die andere Ausführungsvariante der Vorrichtung sieht vor, dass der Giesskopf so angeordnet ist, dass die Auftrefflinie des Giessvorhangs und eine zur Transprtrichtung der Platte (und damit zu den Leiterbahnen in Längsrichtung) senkrechte Linie den spitzen Winkel einschliessen und dass die vorlaufenden Plattenkanten im wesentlichen senkrecht zur Transportrichtung der Platten positioniert sind.

Der eingeschlossene spitze Winkel ist, wie bereits weiter oben erwähnt, kleiner etwa 20° und liegt vorzugsweise im Bereich von etwa 5° bis etwa 15°.

Bei einer besonders vorteilhaften Ausführung der zweitgenannten Ausführungsvariante der Beschichtungsvorrichtung (vorlaufende Plattenkanten im wesentlichen senkrecht zur Transportrichtung) umfassen die Transportmittel Rollenzeilen oder Förderbänder, wobei die Zeilen bzw. Förderbänder im wesentlichen in stumpfem Winkel V-förmig zueinander angeordnet sind, so dass beim Transport die Platten nur an ihren Aussenkanten aufliegen und so eine Beschädigung der Plattenoberflächen vermieden wird.

Eine solche Beschichtungsvorrichtung, wie sie bisher beschrieben ist, eignet sich besonders als Beschichtungsstation in einer Beschichtungsanlage, bei der in der Reihenfolge des Durchlaufs einer Platte durch die Anlage eine Einlaufstation, eine Vortrocknungsstation, dann die genannte Beschichtungsstation, anschliessend eine Kühl- und Nachtrocknungsstation und eine Auslaufstation aufeinander folgen, die in vorteilhafter Weise alle in einem gemeinsamen Gehäuse integriert sind.

Im folgenden wird die Erfindung anhand de Zeichnung näher erläutert; es zeigen, zum Teil in schematischer Darstellung:

Fig. 1 eine Vorrichtung zur Beschichtung von Platten gemäss Stand der Technik

Fig. 2 eine Ausführungsvariante des erfindungsgemässen Verfahrens

Fig. 3 eine weitere Ausführungsvariante des erfindungsgemässen Verfahrens

Fig. 4 ein Ausführungsbeispiel einer erfindungsgemässen Beschichtungsvorrichtung in Seitenansicht

Fig. 5 eine Aufsicht auf ein Ausführungsbeispiel der Beschichtungsvorrichtung

Fig. 6 eine Variante der Transportmittel in Form von V-förmig angeordneten Rollenzeilen zum Transport der Platten

Fig. 7 eine Aufsicht auf ein weiteres Ausführungsbeispiel der Beschichtungsvorrichtung

Fig. 8 eine Anlage mit einer erfindungsgemässen Beschichtungsstation

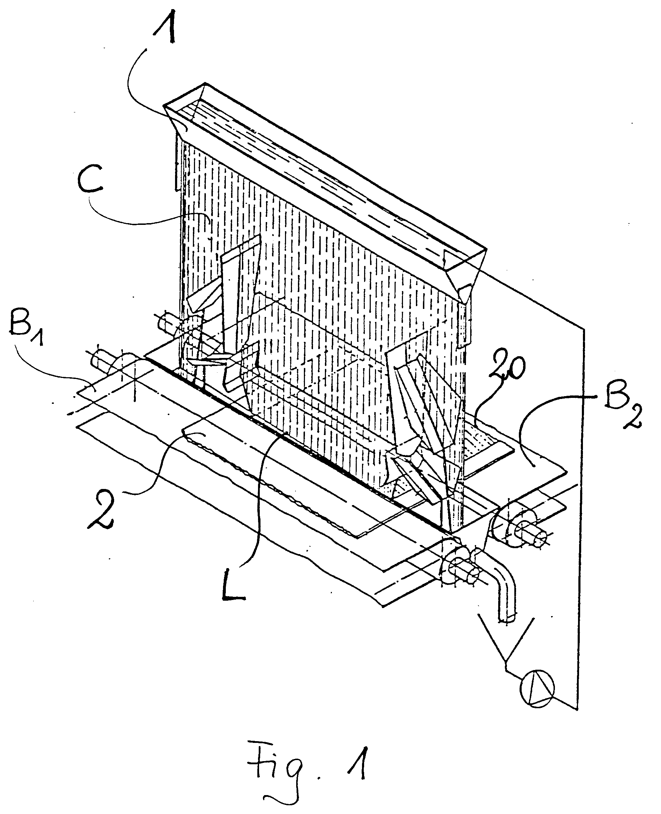

Der in Fig. 1 schematisch dargestellte Ausschnitt aus einer Beschichtungsvorrichtung gemäss dem Stand der Technik verdeutlicht die prinzipielle Funktionsweise des Vorhanggiessens. Ein Giesskopf 1 erzeugt einen Giessvorhang C, der aus einer härtbaren, flüssigen Beschichtungsmasse, z.B. einem lichthärtbaren Kunststoff-Lack, besteht. Die beiden Förderbänder $B_1$ und $B_2$ transportieren eine zu beschichtende Platte 2, beispielsweise eine Leiterplatte, längs einer Transportbahn unter dem Giesskopf 1 vorbei, so dass der herabfallende Giessvorhang C die Platte 2 längs einer Auftrefflinie L beaufschlagt. Durch den Weitertransport der Platte 2 wird so die gesamte Platte 2 beschichtet. Da die Auftrefflinie aber senkrecht zu der vorlaufenden Plattenkante 20 verläuft, kann es zuden in der Einleitung genannten Problemen kommen (Lufteinschlüsse, unvollständige Beschichtung).

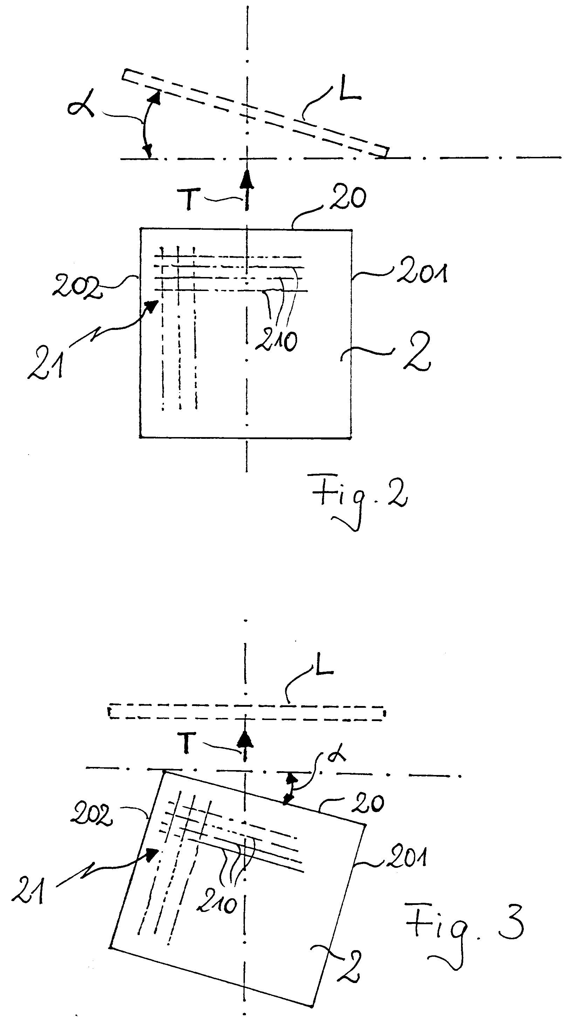

Bei dem erfindungsgemässen Verfahren werden die hier beispielhaft betrachteten Leiterplatten 2 und der Giessvorhang C so gegeneinander ausgerichtet, dass die vorlaufenden Plattenkanten 20 und damit auch die Leiterbahnen 21 auf der Leiterplatte 2 mitdem Giessvorhang C einen spitzen Winkel $\alpha$ einschliessen, wie es in zwei Ausführungsvarianten in den Fig. 2 und 3 dargestellt ist. Dadurch erreicht man, dass eventuell bei der Beschichtung auftretende Lufteinschlüsse in der Beschichtungsmasse abtransportiert werden können. Man stelle sich dazu beispielsweise senkrecht zur Transportrichtung verlaufende Leiterbahnen 210 auf der Platte 2 vor, wobei die Platte 2 unter einem spitzen Winkel $\alpha$ bezogen auf eine Linie senkrecht zur Transportrichtung beschichtet wird (Fig. 2). Ein Zwischenraum zwischen zwei solchen Leiterbahnen 210 wird im hier dargestellten Fall vom rechten Plattenrand 201 beginnend zum linken Plattenrand 202 hin beschichtet, da der rechte Plattenrand 201 auf der Höhe des Zwischenraums zwischen zwei Leiterbahnen 210 zuerstvon dem Giessvorhang C längs der Auftrefflinie L beaufschlagt wird. Um dies zu erreichen wird die Platte 2 so ausgerichtet, dass ihre vorlaufende Plattenkante 20 und damit auch die angedeuteten Leiterbahnen 21 im wesentlichen senkrecht zur Transportrichtung T durch die Beschichtungszone transportiert wird, in der der Giessvorhang C die Platte 2 beaufschlagt.

In einer weiteren Ausführungsvariante, die in Fig. 3 gezeigt ist und zwar ebenfalls in stark vereinfachter Darstellung, verläuft der Giessvorhang bzw. die gestrichelt dargestellte Auftrefflinie L im wesentlichen senkrecht zur Transportrichtung T. Die Leiterplatte 2 wird so positioniert, dass ihre vorlaufende Kante 20 und damit auch die Leiterbahnen 21 einen spitzen Winkel $\alpha$ mit dem Giessvorhang C bzw. der Auftrefflinie L einschliessen. Der spitze Winkel $\alpha$ ist kleiner etwa 20°und liegt vorzugsweise im Bereich von etwa 5°bis 15°. Eine besonders gute Beschichtung wird erzielt, wenn der Winkel $\alpha$ zwischen 8.5°und 11.5°liegt. Die Funktionsweise ist analog der des Verfahrens, wie es anhand Fig. 2 erläutert ist. Der einzige Unterschied ist, dass im hier dargestellten Fall die Zwischenräume zwischen zwei quer zur Transportrichtung T verlaufenden Leiterbahnen 210 vom linken Plattenrand 202 beginnend in Richtung zum rechten Plattenrand 201 hin beschichtet werden.

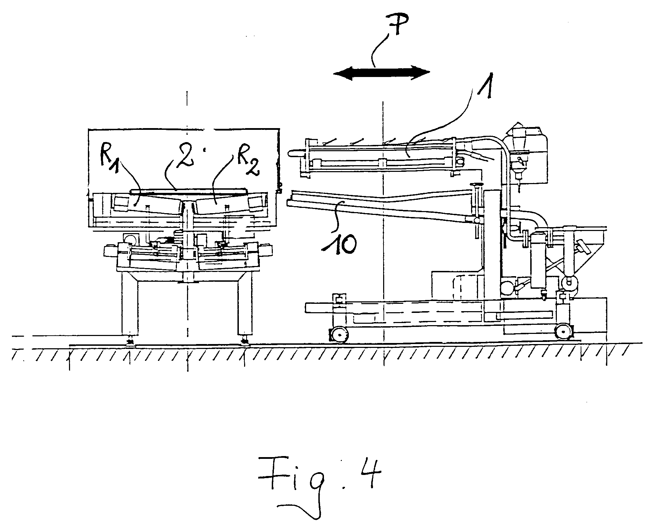

Ein Ausführungsbeispiel einer Vorrichtung zur Beschichtung solcher Platten, insbesondere Leiterplatten 2 mit aufgebrachten Leiterbahnen 21, ist in Fig. 4 in einer Seitenansicht schematisch dargestellt. Der Giesskopf 1 ist dabei über die Transportbahn einfahrbar ausgeführt, wie es durch die Pfeile P angedeutet ist. Weiterhin ist auch noch eine Auffangwanne 10 erkennbar, die die Beschichtungsmasse des Giessvorhangs C auffängt, welche nicht die Platte 2 beaufschlagt. Ferner erkennt man die Transportmittel in Form von im wesentlichen in stumpfem Winkel V-förmig zueinander angeordneten Rollenzeilen $R_1$ und $R_2$, auf denen die zu beschichtende Platte 2 an ihren Plattenrändern 201 und 202 aufliegt und die die Platte 2 unter dem Giesskopf 1 vorbei transportieren.

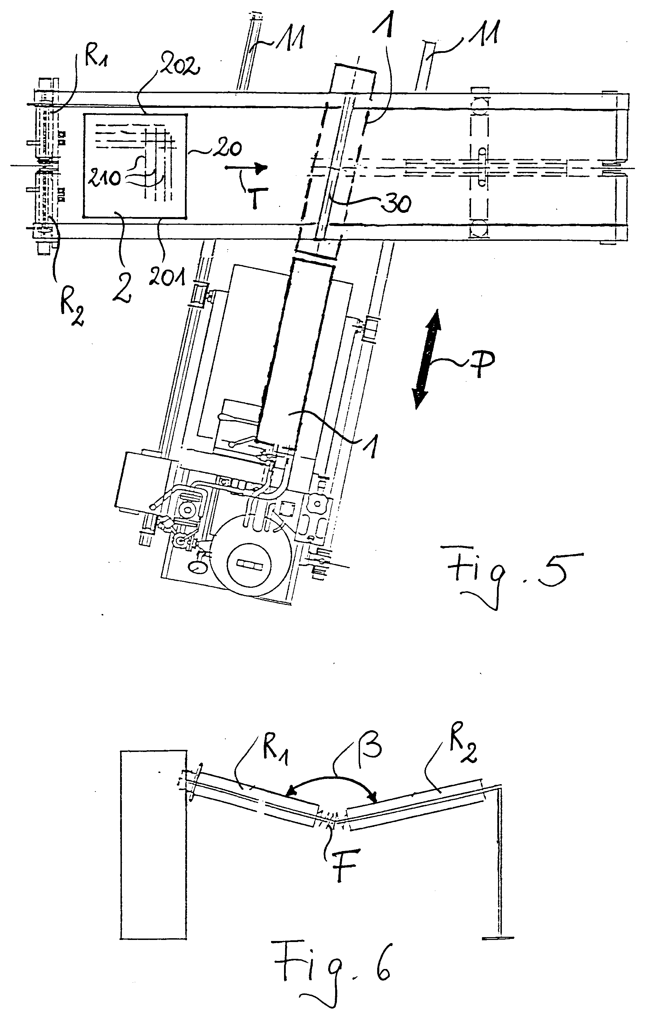

Eine Aufsicht auf die wesentlichen Teile des Ausführungsbeispiels der Beschichtungsvorrichtung ist in Fig. 5 dargestellt. Man erkennt wieder den längs der Schienen 11 in Richtung der Pfeile P über die Transportbahn einfahrbaren Giesskopf 11, dessen Endstellung über der Transportbahn gestrichelt dargestellt ist. Ausserdem sind die V-förmig zueinander angeordneten Rollenzeilen $R_1$ und $R_2$ in Form eines Rollenpaares angedeutet. Diese Rollen sind drehbar gelagert und antreibbar. Sie transportieren die Leiterplatte 2 in Transportrichtung T unter dem Giesskopf 1 vorbei. Die Rollenzeilen $R_1$ und $R_2$ sind entlang der gesamten Transportbahn angeordnet und lediglich im dem Bereich, in dem der Giessvorhang C aus dem Giesskopf 1 herabfällt, durch den Spalt 30 unterbrochen, so dass die herabfallende Beschichtungsmasse, die nicht die Platte 2 beaufschlagt, beispielsweise in der Auffangwanne 10 (Fig. 4) unter dem Spalt 30 aufgefangen werden kann und dem Giesskopf erneut zugeführt und somit wiederverwendet werden kann. Die Auftrefflinie L des Giessvorhangs C auf der Platte 2 verläuft, ähnlich wie der Spalt 30, unter einem spitzen Winkel $\alpha$ bezogen auf eine Linie senkrecht zur Transportrichtung T, während die vorlaufende Plattenkante 20 und damit auch die quer zur Transportrichtung verlaufenden Leiterbähnen 210 im wesentlichen senkrecht zur Transportrichtung T verlaufen. Auf diese Weise können, wie bereits oben erläutert, eventuelle bei der Beschichtung auftretende Lufteinschlüsse abtransportiert und so vermieden werden. Auf diese Weise wird eine vollständige und gleichmässige Beschichtung der Platte 2 erreicht.

Als Transportmittel für die Leiterplatten 2 dienen im oben erläuterten Ausführungsbeispiel die Rollenzeilen $R_1$ und $R_2$. In Fig. 6 ist ein Rollenpaar dieser Rollenzeilen dargestellt. Die Rollen sind beidseitig drehbar gelagert und im wesentlichen in stumpfem Winkel $\beta$ V-förmig zueinander angeordnet. An den einander zugewandten Enden sind die Rollen miteinander gekoppelt, beispielsweise durch eine sehr harte Feder F, so dass sie sich synchron drehen. Dieses synchrone Drehen muss auch gewährleistet sein, da sich die Platte 2 sonst beim Transport gegnüber ihrer Ausgangslage verdrehen könnte. Eine Verdrehung der Platte muss aber vermieden werden, da sonst der eingeschlossene Winkel $\alpha$ sich verändert und bei der Beschichtung wieder Lufteinschlüsse auftreten können bzw. die Beschichtung unvollständig oder ungleichmässig werden kann. Ausserdem kann auch eine Beschädigung der Platte 2 bzw. der Plattenoberfläche die Folge sein, da die Platte ja nur an ihren Plattenkanten 201 und 202 aufliegen soll, was auch insbesondere bei beidseitig zu beschichtenden Platten 2 wichtig ist. Vor allem ist dieses Aufliegen der Platte auf den Plattenkanten 201 und 202 wichtig, wenn die eine Plattenoberfläche gerade erst beschichtet und die Platte danach gedreht worden ist, um nun die andere Plattenoberfläche zu beschichten. Dann kann nämlich die Beschichtungsmasse noch nicht vollständig getrocknet sein. Würde die Plattenoberfläche dann auf den Rollen aufliegen, kann eine Beschädigung der Beschichtung die Folge sein. Liegt die Platte 2 hingegen auf den Plattenkanten 201 und 202 auf, so wird die Plattenoberfläche bzw. die Beschichtung nicht beschädigt. In dem allenfalls kleinen aufliegenden Randbereich bei den Plattenkanten 201 und 202 verlaufen ohnehin in aller Regel keine Leiterbahnen, wie weiter oben bereits diskutiert. Durch die oben beschriebene Kopplung der Rollen wird also eine Verdrehung der Platte 2 und damit eine Beschädigung der Plattenoberfläche vermieden und insbesondere auch eine beidseitige zeitlich kurz aufeinanderfolgende Beschichtung der beiden Oberflächen einer Leiterplatte 2 ermöglicht. Ausserdem ist es aufgrund der Kopplung der Rollen auch nur erforderlich, eine der beiden Rollen anzutreiben (bzw. auf die gesamte Transportbahn bezogen natürlcih eine gesamte Rollenzeile), ohne dass die Bedingung des synchronen Laufes der Rollen verletzt wird.

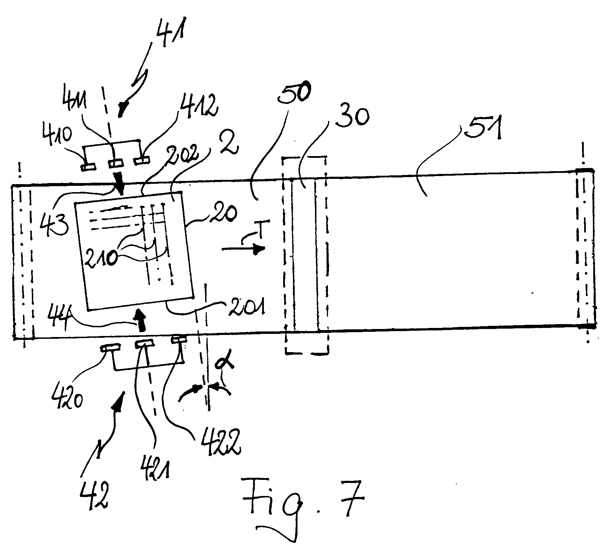

Ein weiteres Ausführungsbeispiel der Beschichtungsvorrichtung ist in Fig. 7 dargestellt. Die zu beschichtende Leiterplatte wird wieder in Transportrichtung T unter dem Giessvorhang vorbei transportiert. Die Auftrefflinie L des Giessvorhangs verläuft hier allerdings, im Unterschied zum Ausführungsbeispiel gemäss Fig. 5, im wesentlichen senkrecht zur Transportrichtung T der Platte 2; entsprechend verläuft natürlich auch der Spalt 30 in der Transportbahn, unter dem wieder eine Auffangwanne (Fig. 4) für die Beschichtungsmasse vorgesehen sein kann, ebenfalls im wesentlichen senkrecht zur Transportrichtung T. Um trotzdem zu gewährleisten, dass zwischen der vorlaufenden Plattenkante 20 bzw. den quer zur Transportrichtung verlaufenden Leiterbahnen 210 und der Auftrefflinie des Giessvorhangs der gewünschte spitze Winkel $\alpha$ zwecks Vermeidung von Lufteinschlüssen bei der Beschichtung eingeschlossen ist, muss die Platte 2 entsprechend positioniert werden, bevor sie den Giessvorhang erreicht. Zu diesem Zweck umfassen die Transportmittel eine Positioniereinrichtung, die hier in Fig. 6 durch die rechenartig ausgebildeten Positionierer 41 und 42 mit ihren Anschlagflächen 410,411,412 bzw. 420,421,422 symbolisch angedeutet sind. Diese Anschlagflächen werden gemäss den Pfeilen 43 und 44 an die Platte 2 herangeführt und richten sie aus, wie in Fig. 7 gezeigt. Nach diesem Ausrichten schliesst die vorlaufende Kante 20 der Platte 2 und damit die quer zur Transportrichtung angeordneten Leiterbahnen 210 den gewünschten spitzen Winkel $\alpha$ mit der Auftrefflinie des Giessvorhangs ein, so dass Lufteinschlüsse bzw. eine unvollständige oder ungleichmässige Beschichtung vermieden werden. Nach der Beschichtung kann die Platte 2 selbstverständlich wieder positioniert werden, so dass die vorlaufende Plattenkante 20 wieder im wesentliche senkrecht zur Transportrichtung T verläuft, falls dies erforderlich ist. Bei diesem Ausführungsbeispiel der Beschichtungsvorrichtung können allerdings die Rollenzeilen $R_1$ und $R_2$, wie sie anhand von Fig. 5 erläutert worden sind, nicht als Transportmittel verwendet werden. Beispielsweise können aber Transportbänder 50 und 51 vorgesehen sein, wie sie in Fig. 7 dargestellt sind. Es sind auch Klammern (nicht dargestellt) denkbar, die die bereits positionierte Platte 2 an den Plattenkanten 201 und 202 greift und sie entprechend positioniert unter dem Giessvorhang vorbei transportiert Dies kann insbesondere dann vorteilhaft sein, wenn beide Plattenoberflächen zeitlich kurz aufeinander folgend beschichtet werden sollen, so dass die Beschichtung der zuerst beschichteten Oberfläche noch nicht vollständig getrocknet ist.

Zuden beschriebenen Beschichtungsvorrichtungen sind natürlich viele weitere Ausführungen denkbar. Beispielsweise können in dem anhand Fig. 5 erläuterten Ausführungsbeispiel statt der Rollenzeilen auch durch entsprechend angeordnete Förderbänder vorgesehen sein, so dass die Plattenkanten 201 und 202 auf diesen Förderbändern aufliegen. Allerdings müssen auch diese Förderbänder synchron angetrieben werden. Auch können die Transportmittel beispielsweise durch Klammern, die an den Plattenkanten 201 und 202 angreifen, realisiert sein. Weiterhin kann bei diesem Ausführungsbeispiel auch eine separate rechenartige (wie anhand Fig. 7 erläutert) oder andersartige Positioniereinrichtung vorgesehen sein, die die einlaufende Platte 2 zentriert, also mittig auf die Rollenzeilen $R_1$ und $R_2$ so aufbringt, dass die vorlaufende Plattenkante 20 und damit auch die Leiterbahnen 210 senkrecht zur Transportrichtung T verlaufen. Ausserdem kann die Positioniereinrichtung auch eine beliebige andere Ausgestaltung aufweisen, solange sie nur die Platte entsprechend der Ausführungsform der Beschichtungsvorrichtung positionieren kann. Weiterhin kann der Giesskopf 1 und die Auffangwanne 10 selbstverständlich auch mit dem Rest der Vorrichtung eine bauliche Einheit bilden oder ausschwenkbar sein, er muss nicht wie hier erläutert, längs Schienen 11 ausfahrbar sein.

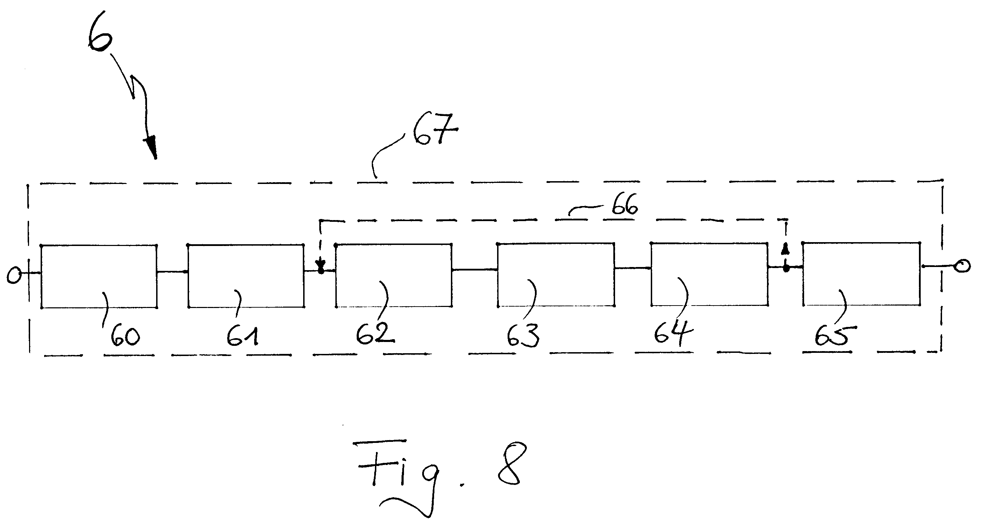

Besonders vorteilhaft ist eine Beschichtungsvorrichtung, wie sie bis hierher erläutert ist, wenn sie als Beschichtungsstation in einer Beschichtungsanlage integriert ist. Eine solche Beschichtungsanlage 6 ist in einem Blockschaltbild in Fig. 8 angedeutet. In der Reihenfolge des Durchlaufs einer Platte durch die Anlage folgen dabei eine Einlaufstation 60, eine Vortrocknungsstation 61, dann die Beschichtungsstation 62, eine Trocknungsstation 63, eine Nachtrocknungs- und Kühlstation 64 sowie eine Auslaufstation 65 aufeinander. Soll die Platte beidseitig beschichtet werden, so kann zu diesem Zweck die einseitig beschichtete Platte nach der Nachtrocknungs- und Kühlstation 64 bzw. eventuell auch schon nach der Trocknungsstation 63 zurück zur Beschichtungsstation 62 geführt werden, wie durch die gestrichelte Linie 66 angedeutet ist. Vor einer erneuten Beschichtung muss sie dann aber zunächst gewendet werden. Nach dem zweiten Durchlauf kann die dann erneut getrocknete und gekühlte Platte 2 dann weitertransportiert werden, z.B. zum Bohren, Bestücken und Belöten. Eine solche Anlage ist vorteilhafterweise in einem Gehäuse integriert, das durch die gestrichelte Linie 67 angedeutet ist.

Beschichtungsvorrichtungen und -anlagen der beschriebenen Art eignen sich besonders für die Beschichtung von Leiterplatten, auf denen Leiterbahnen von einer Höhe von beispielsweise 120 $\mu$m aufgebracht sind, mit lichthärtbarem, insbesondere UV-lichthärtbarem Kunststoff-Lack.

**Patentansprüche**

1. Verfahren zur Beschichtung von Platten insbesondere Leiterplatten mit härtbarer flüssiger Beschichtungsmasse, insbesondere lichthärtbarem Kunststoff-Lack, wobei die Platten zur Beschichtung längs einer Transportbahn durch eine Beschichtungszone transportiert und dort von einem herabfallenden Giessvorhang (C) beaufschlagt werden, dadurch gekennzeichnet, dass die Platten (2) und der Giessvorhang (C) so gegeneinander ausgerichtet werden, dass die vorlaufenden Plattenkanten (20) mit dem Giessvorhang (C) einen spitzen Winkel ($\alpha$) einschliessen.

2. Verfahren nach Anspruch 1, dadurch gekennzeichnet, dass der Giessvorhang (C) im wesentlichen senkrecht zur Transportrichtung (T) verläuft und die Platten (2) so positioniert werden, dass ihre vorlaufenden Kanten (20) den spitzen Winkel ($\alpha$) mit dem Giessvorhang (C) einschliessen.

3. Verfahren nach Anspruch 1, dadurch gekennzeichnet, dass die Platten (2) mit im wesentlichen senkrecht zur Transportrichtung (T) ausgerichteten vorlaufenden Kanten (20) durch die Beschichtungszone transportiert werden und der Giessvorhang (C) so angeordnet ist, dass die Auftrefflinie (L) schräg zur Transportrichtung (T) geneigt ist.

4. Verfahren nach einem der Ansprüche 1 bis 3, dadurch gekennzeichnet, dass der spitze Winkel ($\alpha$) etwa kleiner 20° ist und vorzugsweise im Bereich von etwa 5° bis etwa 15° liegt.

5. Vorrichtung zur Beschichtung von Platten, insbesondere Leiterplatten, mit einem Giesskopf (1) zur Erzeugung eines frei fallenden Giessvorhangs (C) aus flüssiger Beschichtungsmasse, insbesondere einem lichthärtbaren Kunststoff-Lack, und mit Transportmitteln ($R_1$,$R_2$) zum Transportieren der zu beschichtenden Platten (2) längs einer Transportbahn unter dem Giesskopf (1) vorbei, dadurch gekennzeichnet, dass der Giesskopf (1) und/oder die Transportmittel so ausgebildet bzw. angeordnet sind, dass die vorlaufenden Kanten (20) der zu beschichtenden Platten (2) während der Beschichtung mit dem Giessvorhang (C) einen spitzen Winkel ($\alpha$) einschliessen.

6. Vorrichtung nach Anspruch 5, dadurch gekennzeichnet, dass die Transportmittel eine Positioniereinrichtung (41,42) umfassen, welche die Platten (2) vor der Beschichtung so positioniert, dass die vorlaufenden Kanten (20) der Platten (2) und eine zur Transportrichtung senkrechte Linie den spitzen Winkel ($\alpha$) einschliessen, und dass der Giesskopf (1) so angeordnet ist, dass die Auftrefflinie (L) des Giessvorhangs (C) im wesentlichen senkrecht zur Transportrichtung (T) der Platte (2) verläuft.

7. Vorrichtung nach Anspruch 5, dadurch gekennzeichnet, dass der Giesskopf (1) so angeordnet ist, dass die Auftrefflinie (L) des Giessvorhangs (C) und eine zur Transportrichtung (T) senkrechte Linie den spitzen Winkel ($\alpha$) einschliessen.

8. Vorrichtung nach einem der Ansprüche 5 bis 7, dadurch gekennzeichnet, dass der spitze Winkel ($\alpha$) Kleiner etwa 20° ist und vorzugsweise im Bereich von etwa 5° bis etwa 15° liegt.

9. Vorrichtung nach einem der Ansprüche 5 bis 8, dadurch gekennzeichnet, dass die Transportmittel im wesentlichen in stumpfem Winkel V-förmig zueinander angeordnete Rollenzeilen ($R_1$,$R_2$) oder Förderbänder umfassen, die die Platte (2) transportieren.

10. Anlage zur Beschichtung von Platten (2), insbesondere Leiterplatten, bei der in der Reihenfolge des Durchlaufs einer Platte durch die Anlage eine Einlaufstation (60), eine Vortrocknungsstation (61), eine Beschichtungsstation (62), eine Trocknungsstation (63), eine Kühl- und Nachtrocknungsstation (64) und eine Auslaufstation (65) aufeinander folgen, die alle in einem gemeinsamen Gehäuse (67) integriert sind, dadurch gekennzeichnet, dass die Beschichtungsstation (62) durch eine Vorrichtung gemäss Anspruch 5 bis 9 gebildet ist.

11. Anlage nach Anspruch 10, dadurch gekennzeichnet, dass nach der Kühl- und Nachtrocknungsstation (64) eine Rückführung (66) für eine einseitig beschichtete Platte (2) vorgesehen ist, welche die Platte (2) zurück zur Beschichtungsstation (62) führt und wendet.

Fig. 1

7

Fig. 2

Fig. 3

Fig. 4

Fig. 5

Fig. 6

Fig. 7

Fig. 8

Europäisches
Patentamt

**EUROPÄISCHER RECHERCHENBERICHT**

Nummer der Anmeldung

EP    91 81 0077

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| X | DE-B-1 150 009 (ROBERT BüRKLE & CO. MASCHINENFABRIK) <br> * das ganze Dokument * <br> ----- | 1-3,5-7, 10 | B05C5/00 |
| | | | **RECHERCHIERTE SACHGEBIETE (Int. Cl.5 )** |
| | | | B05C |

Der vorliegende Recherchenbericht wurde für alle Patentansprüche erstellt

| Recherchenort | Abschlußdatum der Recherche | Prüfer |
|---|---|---|
| DEN HAAG | 02 OCTOBER 1991 | JUGUET J.M. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
...........................................................................
& : Mitglied der gleichen Patentfamilie, übereinstimmendes
    Dokument

EPO FORM 1503 03.82 (P0403)